# EUROPÄISCHE PATENTSCHRIFT

(11) **EP 3 523 466 B1**
(45) Veröffentlichungstag und Bekanntmachung des Hinweises auf die Patenterteilung: **19.02.2020**
(21) Anmeldenummer: 17784531.0
(22) Anmeldetag: 04.10.2017
(51) Int. Cl.: C30B 25/10, C23C 16/27, C30B 25/14, C30B 25/16, C30B 29/04, C23C 16/455

(54) **VORRICHTUNG UND VERFAHREN ZUM AUFBRINGEN EINER KOHLENSTOFFSCHICHT**
DEVICE AND METHOD FOR APPLYING A CARBON LAYER
DISPOSITIF ET PROCÉDÉ D'APPLICATION D'UNE COUCHE DE CARBONE

(30) Priorität: 04.10.2016 AT 508942016
(43) Veröffentlichungstag der Anmeldung: 14.08.2019
(73) Patentinhaber: CarbonCompetence GmbH, 6112 Wattens (AT)
(72) Erfinder: STEINMÜLLER-NETHL, Doris, 6071 Aldrans (AT); STEINMÜLLER, Detlef, 6071 Aldrans (AT)
(74) Vertreter: Sonn & Partner Patentanwälte
(86) Internationale Anmeldenummer: PCT/AT2017/060248
(87) Internationale Veröffentlichungsnummer: WO 2018/064694

(56) Entgegenhaltungen:
- WO-A1-95/06143
- JP-A- H05 890
- JP-A- S5 891 100
- JP-A- S61 163 195
- US-A- 5 479 874

## Beschreibung

Die Erfindung betrifft eine Vorrichtung gemäß dem Oberbegriff von Anspruch 1.

Weiters betrifft die Erfindung ein Verfahren gemäß dem Oberbegriff von Anspruch 10. Aus der DE 689 09 491 T2 ist eine Vorrichtung zum Aufbringen von Diamantschichten durch chemische Gasphasenabscheidung bekannt, welche eine zylindrische Reaktionskammer aufweist, die an gegenüberliegenden Enden durch Platten abgeschlossen ist. Durch die obere Platte erstrecken sich vier Molybdänstäbe in das Innere der Reaktionskammer, wobei die freien Enden einen Abstand zur unteren Platte aufweisen. Um zwei Stäbe befindet sich ein offenes Quarzrohr, welches axial im Zylinder angeordnet ist. Eine Gaseintrittsöffnung in der oberen Platte steht mit dem Rohr in Verbindung, während eine weitere Gaseintrittsöffnung mit dem nicht vom Rohr eingenommenen Volumen des Zylinders in Verbindung steht. Ein elektrischer Widerstandserhitzer in Form einer Heizspule (Filamente) ist zwischen jeweils zwei der Molybdänstäbe angeordnet und bringt die jeweiligen Prozessgase mittels thermischer Anregung auf die für die Diamantabscheidung benötigte Temperatur. Die Stäbe sind über getrennte Steuerungseinrichtungen mit einer Stromquelle verbunden. Durch die Bodenplatte ragt eine Antriebswelle, welche mit einem Drehteller verbunden ist. Am Drehteller ist das zu beschichtende Substrat angeordnet. Durch die Rotation des Drehtellers ist das Substrat somit abwechselnd unterhalb einer der beiden Gaseintrittsöffnungen angeordnet, und wird dadurch einerseits mit kohlenstoffhaltigen Gasen in Kontakt gebracht, wodurch eine Diamantschicht abgeschieden wird, und andererseits mit kohlenstofffreien Gasen in Kontakt gebracht, wodurch nicht diamantartige Kohlenstoffabscheidungen entfernt werden. Dieses sogenannte "hot-filament" Verfahren hat sich - neben einem Mikrowellen-unterstützten Verfahren - etabliert. Die JP H05890 A beschreibt eine CVD (Chemical Vapor Deposition) Anlage, die zur Erwärmung von Wasserstoff heizbare, an eine Kammer angebrachte Kapillaren verwendet. Die Kapillaren sind an einem Ende offen, so dass sich bei der Erwärmung kein Druck aufbauen kann. Somit wird keine Stoßanregung erzielt.

Aus der US 5479874 A ist weiters eine CVD-Anlage bekannt, welche mit einem Vorheizer ein Prozessgas vorheizt, bevor dieses mit Heizdrähten auf die endgültige Betriebstemperatur gebracht wird. Auch bei diesem Stand der Technik ist keine Stoßanregung vorgesehen.

Die JP S61 163195 A offenbart eine CVD-Anlage mit einem Kessel, bei der Gas durch ein Versorgungsrohr in ein widerstandsbeheiztes Auslassrohr mit Löchern geleitet wird, wobei die Löcher einem Substrat im Kessel zugewandt sind. Zusätzlich ist das Auslassrohr mit einem Wasserkühlrohr verbunden. Ein weiteres Prozessgas wird im Hintergrund direkt in den Kessel zugelassen.

WO 95/06143 A1 zeigt eine Einrichtung zum thermischen Dissoziieren von Gasen mit einem einseitig offenen, beheizbaren Rohr aus Wolfram.

Die JP S58 91100 A zeigt eine Vorrichtung, bei der kohlenstoffhaltiges Prozessgas thermisch aktiviert wird.

Ein Nachteil so genannter "hot-filament"-Verfahrens zur Diamantabscheidung ist, dass die Anregungsrate bei der thermischen Anregung der Prozessgase mit der Heizspule eher gering ist und kein lokaler, kontrollierter Einfluss auf die Anregung der einzelnen Gassorten genommen werden kann. Darüber hinaus kann eine Abscheidung von Diamant auf dem Substrat vielfach nur in einem Abstand von wenigen Millimetern bis einigen Zentimetern zu den Filamenten gewährleistet werden. Aufgrund der geringen aktiven Wachstumsspezies ist die Wachstumsrate vergleichsweise gering. Insgesamt ist das bekannte Verfahren nicht nur zeitaufwendig und kostenintensiv, sondern auch schwer kontrollierbar.

Demnach besteht die Aufgabe der vorliegenden Erfindung darin, zumindest einzelne Nachteile des Standes der Technik zu beseitigen oder zumindest zu lindern. Die Erfindung setzt sich daher insbesondere zum Ziel, eine Vorrichtung und ein Verfahren zu schaffen, mit welcher bzw. mit welchem die Anregungsrate des Prozessgases, insbesondere von Wasserstoff, verbessert wird, eine homogene Abscheidung der Kohlenstoffschicht auf dem Substrat ermöglicht wird und vorzugsweise eine bessere Steuerung des Beschichtungsprozesses insbesondere für große Beschichtungsflächen und komplex geformte Substrate ermöglicht wird.

Diese Aufgabe wird durch eine Vorrichtung mit den Merkmalen von Anspruch 1 und durch ein Verfahren mit den Merkmalen von Anspruch 10 gelöst. Bevorzugte Ausführungsformen sind in den abhängigen Ansprüchen angegeben.

Erfindungsgemäß ist ein Gaseinleit- und Gasaktivierungselement in Form eines Hohlkörpers mit einem Strömungskanal für das Prozessgas, einer den Strömungskanal umgebenden Wandung und einer vom Strömungskanal in die Abscheidekammer mündenden Austrittsöffnung und eine Heizvorrichtung zum Aufheizen der Wandung des Gaseinleit- und Gasaktivierungselementes vorgesehen. Die Heizvorrichtung ist dazu eingerichtet, das im Strömungskanal des Gaseinleit- und Gasaktivierungselements strömende Prozessgas durch Stoßanregung und thermische Anregung anzuregen.

Bei einer bevorzugten Anwendung wird eine Diamantschicht auf einem Substrat, beispielsweise ein Hartmetallwerkzeug, ein Silizium Wafer, ein Titanimplantat, ein Schmuckstein, ein Sensor-/CMOS-Bauteil, etc., abgeschieden. Bei dieser Ausführung erfolgt die Abscheidung durch die Anregung eines kohlenstoffhaltigen Gases, insbesondere Methan, aber auch Ethylen, Acetylen etc. Durch die Anregung können die Kohlenstoffatome angeregt werden und somit chemische Radikale (z.B. Methylradikale) bilden, welche dann auf dem speziell präparierten Substrat zum Diamantwachstum (sp3-hybridisierter Kohlenstoff) führen. Neben Diamant können auch andere Kohlenstoffmodifikationen, beispielsweise Graphit (sp2-hybridisierter Kohlenstoff) oder Polymere (sp-hybridisierter Kohlenstoff) gebildet werden. Um die unerwünschten Kohlenstoffmodifikationen zu unterbinden bzw. zu entfernen, wird atomarer Wasserstoff zum Ätzen der unerwünschten Spezies benötigt. Um dies zu realisieren, wird bei dieser Ausführung molekulares Wasserstoffgas durch das Gaseinleit- und Gasaktivierungselement dissoziiert, so dass der ausströmende, angeregte, atomare Wasserstoff die unerwünschten Kohlenstoffmodifikationen wie z.B. Graphit, Polymere, etc. "wegätzt" und damit die Bildung einer reinen Diamantstruktur fördert. Weiters heizt der atomare Wasserstoff durch Rekombination die zu beschichtenden Teile und ist somit ein wesentlicher Energieträger. Außerdem finden weitere chemische und katalytische Prozesse durch Stöße des atomaren Wasserstoffs mit dem kohlenstoffhaltigen Gas statt. Somit wird die Effektivität der Anregung erhöht. Eine möglichst hohe Anregungsrate von Wasserstoff ist somit von besonderer Bedeutung. Die Diamantabscheidung erfolgt in einer Abscheidekammer, in welcher vorzugsweise ein Unterdruck, in einer besonderen Ausführungsform im mbar-Bereich, herrscht. Die Prozessgase sind vorzugsweise Methan und Wasserstoff. Vorzugsweise werden der Wasserstoff und das kohlenstoffhaltige Prozessgas separat in die Abscheidekammer eingeleitet. Dabei werden die Prozessgase aktiviert, um die anschließende Abscheidung einer Diamantschicht auf dem Substrat zu erreichen. Alternativ können die Prozessgase gemeinsam, insbesondere in Form einer Mischung aus Methan und Wasserstoff, über das Gaseinleit- und Gasaktivierungselement in die Abscheidekammer eingeleitet werden. Um die Bildung einer Diamantschicht an der Oberfläche des Substrats zu begünstigen, erfolgt diese Reaktion vorzugsweise unter reduziertem Druck. Bei dem "hot-filament"-Verfahren des Standes der Technik erfolgt die Anregung der Prozessgase ausschließlich durch thermische Anregung über einen beheizten Draht. Nachteilig ist, dass dadurch lediglich Anregungsraten von atomarem Wasserstoff von beispielsweise 20% erreicht werden können. Dies hängt insbesondere damit zusammen, dass die Anregung beim "hotfilament"-Verfahren nur thermisch und in der unmittelbaren Nähe des Heizdrahtes erfolgt. Bei der erfindungsgemäßen Vorrichtung wird hingegen die Wandung des Gaseinleit- und Gasaktivierungselements, vorzugsweise über dessen gesamte Länge, aufgeheizt. Zu diesem Zweck ist die Wandung des Gaseinleit- und Gasaktivierungselements mit einer Heizvorrichtung verbunden, welche eine unmittelbare Aufheizung der Wandung des Gaseinleit- und Gasaktivierungselements bewirkt. Vorteilhafterweise kann daher das Prozessgas nicht nur thermisch, sondern durch eine Kombination aus thermischer Anregung und Stoßanregung angeregt werden. Dadurch können Anregungsraten von atomarem Wasserstoff von über 80% erreicht werden. Dies erlaubt eine Beschleunigung des Wachstums von Diamantschichten mit hoher Reinheit und eine energieeffizientere Abscheidung mit hohen Wachstumsraten. Weiters wird durch das Verfahren eine höhere Wachstumsrate der Diamantschicht gegenüber dem Stand der Technik realisiert.

Zum Abschluss des Strömungskanals sind Abschlusskörper an (längsseitigen) Enden des Gaseinleit- und Gasaktivierungselements angebracht. Die Abschlusskörper können ein- oder mehrteilig mit der beheizbaren Wandung des Gaseinleit- und Gasaktivierungselementes gebildet sein. Bevorzugt ist das Gaseinleit- und Gasaktivierungselement abgesehen von einer Eintrittsöffnung, durch welche das Prozessgas, insbesondere Wasserstoff, in den Strömungskanal des Gaseinleit- und Gasaktivierungselements geführt wird, und der Austrittsöffnung(en) geschlossen ausgebildet. Durch die Abschlusskörper kann es innerhalb des Gaseinleit- und Gasaktivierungselements zu einem Anstieg des Partialdrucks kommen, wodurch vorteilhafterweise zusätzlich zur thermischen Anregung auch eine Stoßanregung realisiert wird. Darüber hinaus kann die mittlere freie Weglänge der aktivierten Teilchen auf bis zu mehrere Zentimeter ansteigen, wodurch der Abstand zum Substrat erhöht werden kann, was wiederum eine gleichmäßigere Kohlenstoffschicht zur Folge hat.

Vorzugsweise weist das Gaseinleit- und Gasaktivierungselement bei einem kreisförmigen Querschnitt einen Innendurchmesser von 0,1 mm bis 15 mm auf. Dadurch wird der Druck stark reduziert und die Stoßanregungen mit der Wandung werden erhöht.

Für die Zwecke dieser Offenbarung beziehen sich die Orts- und Richtungsangaben, wie "oben", "unten" etc., auf den bestimmungsgemäßen Betriebszustand der Vorrichtung, wenn eine Diamantschicht auf dem Substrat abgeschieden wird.

In einer bevorzugten Ausführungsform ist die Heizvorrichtung zum Aufheizen der Wandung des Gaseinleitelementes auf eine Temperatur von mehr als 2000 °C, insbesondere von mehr als 2200 °C, vorzugsweise von mehr als 2400 °C, eingerichtet. Dadurch wird das Prozessgas auf die benötigte Anregungstemperatur gebracht, damit das Prozessgas, insbesondere Wasserstoffgas, für den Abscheideprozess aktiviert wird.

Für eine effiziente Ätzung von Graphit und anderen unerwünschten Kohlenstoffmodifikationen sind bei einer bevorzugten Anwendung hohe Mengen von atomarem Wasserstoff vorteilhaft, welche mit Hilfe des Gaseinleit- und Gasaktivierungselements erzielt werden können. Weiters kann durch die vergleichsweise große Menge an atomarem Wasserstoff die Kristallitgröße gering gehalten werden (nämlich durch Erhöhung der Sekundärnukleation) und es können hochgradig reine Diamantkristalle im Nanometerbereich abgeschieden werden.

In einer bevorzugten Ausführungsform weist die Heizvorrichtung eine mit der Wandung des Gaseinleit- und Gasaktivierungselements verbundene Stromversorgung für eine Widerstandsheizung des Gaseinleit- und Gasaktivierungselements auf. Bei dieser Ausführungsform lässt sich der Aufheizvorgang schnell und präzise steuern. Weiters ist diese Ausführungsvariante konstruktiv einfach und kostengünstig. Die Widerstandsheizung weist, wie im Stand der Technik hinlänglich bekannt, eine Stromversorgung bzw. Stromquelle auf, mit welcher ein elektrischer Strom durch die Wandung des Gaseinleit- und Gasaktivierungselements geführt wird. Dabei wird die elektrische Energie des elektrischen Stromes in Wärmeenergie umgesetzt. Eine derartige Widerstandsheizung kann an der Außenseite der Abscheidekammer angeordnet sein. Mittels einer Kabelverbindung und gegebenenfalls einer Vakuumdurchführung kann die Widerstandsheizung auch von der Abscheidekammer entfernt angeordnet sein.

In einer besonders bevorzugten Ausführungsform ist das Gaseinleit- und Gasaktivierungselement im Wesentlichen horizontal in der Abscheidekammer angeordnet. Durch diese Anordnung kann ein gleichmäßiger Abstand zwischen dem Gaseinleit- und Gasaktivierungselement und dem zu beschichtenden Substrat gewährleistet werden. Vorteilhafterweise wird so die Abscheidung einer Diamantschicht bevorzugt, welche über die gesamte Oberfläche des Substrats eine gleichmäßige Dicke aufweist. Auf diese Weise kann eine qualitativ hochwertige Schicht erhalten werden.

Insbesondere um eine homogene Diamantschicht mit möglichst gleichmäßiger Schichtdicke entlang der Substratoberfläche weiter zu begünstigen und damit die Qualität der Diamantschicht weiter zu erhöhen, ist die zumindest eine Austrittsöffnung, aus welcher das Prozessgas aus dem Gaseinleit- und Gasaktivierungselement in Richtung Substrat austritt, vorzugsweise an einer dem Substrat zugewandten Unterseite des Gaseinleit- und Gasaktivierungselements angeordnet. Bei dieser Ausführungsform strömt das aktivierte Prozessgas, insbesondere atomarer Wasserstoff, nach dem Austritt aus dem Gaseinleit- und Gasaktivierungselement direkt in Richtung des Substrats.

Gemäß einer bevorzugten Ausführungsform beträgt das Verhältnis zwischen der Fläche genau einer Austrittsöffnung und der Querschnittsfläche des Gaseinleit- und Gasaktivierungselements 1:5 bis 1:20, insbesondere 1:10.

Durch einen kleinen Querschnitt des Gaseinleit- und Gasaktivierungselements und die damit einhergehende Erhöhung des Partialdrucks im Gaseinleit- und Gasaktivierungselement wird die Stoßanregung weiter verstärkt, wodurch wiederum die Anregungsrate des Prozessgases, insbesondere Wasserstoff, und die Qualität der Diamantschicht erhöht werden.

Gemäß einer besonders bevorzugten Ausführungsform weist das Gaseinleit- und Gasaktivierungselement mehrere Austrittsöffnungen auf. Das angeregte Prozessgas (atomarer Wasserstoff) strömt dadurch in einer gleichmäßigen räumlichen Verteilung in Richtung des Substrats, wodurch eine gleichmäßige Abscheidung des gewünschten sp3-hybdisierten Kohlenstoffs auf der Substratoberfläche erzielt werden kann. Damit wird die Bildung einer homogenen, reinen Diamantschicht gefördert. Diese Austrittsöffnungen können alternierend unter einem Winkel zueinander angebracht sein, um einen größeren Volumenbereich für die Beschichtung abzudecken. Ferner kann das Prozessgas zwischen dem Gaseinleit- und Gasaktivierungselement und dem Substrat noch homogener verteilt werden, wenn eine Vielzahl kleinflächiger Austrittsöffnungen vorliegen. Durch Strömungsrechnungen kann eine optimale Geometrie und Anordnung der Austrittsöffnungen bestimmt werden. Damit kann eine noch gleichmäßigere Dicke und eine hohe, kontrollierte Homogenität der Diamantschicht erreicht werden.

Gemäß einer weiteren bevorzugten Ausführungsform ist das Gaseinleit- und Gasaktivierungselement im Querschnitt im Wesentlichen kreisförmig oder rechteckig. Dadurch kommt es zu einer weiteren Erhöhung der Stoßanregung des Prozessgases.

Um Substrate verschiedener Größe und Form beschichten zu können, sind bevorzugt mehrere Gaseinleit- und Gasaktivierungselemente vorgesehen, welche mittels der Heizvorrichtung beheizbar sind. Die Mehrzahl von Gaseinleit- und Gasaktivierungselementen können in der Abscheidekammer derart angeordnet werden, dass eine gleichmäßige Abscheidung einer Diamantschicht auf dem Substrat gewährleistet wird. Beispielsweise können mehrere Gaseinleit- und Gasaktivierungselemente parallel zueinander und in einem gleichen vertikalen Abstand zu dem Substrat angeordnet werden. Dies ist insbesondere von Vorteil, wenn ein Substrat mit einer großen horizontalen Fläche, etwa mehrere Silizium-Wafer, beschichtet werden sollen. Vorteilhafterweise kann eine homogene Beschichtung der gesamten Fläche, etwa der Silizium-Wafer, ermöglicht werden. Die Orientierung der Gaseinleit- und Gasaktivierungselemente ist bevorzugt an die Form des Substrats anpassbar. Die verschiedenen Gaseinleit- und Gasaktivierungselemente können auch an getrennte Gaszuführungen angeschlossen sein, wodurch jeweils verschiedene Prozessgase über die einzelnen Gaseinleit- und Gasaktivierungselemente in die Abscheidekammer geleitet werden können. Die Heizvorrichtung kann derart ausgestaltet sein, dass die Gaseinleit- und Gasaktivierungselemente getrennt voneinander oder auch in einer oder mehreren Gruppen zusammen beheizbar sind. Die Form und Anordnung der Gaseinleit- und Gasaktivierungselemente kann beliebig gestaltet sein und orientiert sich bevorzugt an der Form des zu beschichtenden Bauteils.

Es ist ein weiteres Gaseinleitelement zur Einbringung eines weiteren Prozessgases, nämlich eines kohlenstoffhaltigen Gases, vorzugsweise Methan, in die Abscheidekammer vorgesehen. Somit können die Prozessgase, insbesondere ein kohlenstoffhaltiges Gas und Wasserstoff, sowohl räumlich als auch zeitlich getrennt voneinander in die Abscheidekammer eingeleitet werden. Dadurch können unter anderem die Temperatur, die Einleitgeschwindigkeit in die Abscheidekammer, die zeitliche Abfolge der verschiedenen Prozessgase oder deren Konzentration jeweils für das kohlenstoffhaltige Prozessgas und das Wasserstoffgas individuell und lokal eingestellt werden. Diese Parameter können demnach für Beschichtungsprozesse mit unterschiedlichen Anforderungen optimiert werden. Die Anforderungen können beispielsweise die Dicke der Diamantschicht, deren Reinheit, Dauer des Beschichtungsverfahrens, Form und Material des Substrats, Korngröße, etc. sein.

Gemäß einer weiteren bevorzugten Ausführungsform besteht die Wandung des Gaseinleit- und Gasaktivierungselements aus einem Metall, insbesondere Tantal, Molybdän, Wolfram, Rhenium, oder einem Keramikmaterial oder Graphit oder pyrolytischem Kohlenstoff oder einem Kompositmaterial daraus oder aus einem vorzugsweise faserverstärkten Kohlenstoff, insbesondere mit einer Beschichtung aus Pyrokohlenstoff. Selbstverständlich soll die Erfindung nicht auf die genannten Materialien beschränkt sein. Diese Materialien zeichnen sich durch einen hohen Schmelzpunkt aus, welcher erforderlich ist, um den für die Anregung benötigten hohen Temperaturen von insbesondere über 2000 °C standhalten zu können. Durch die Verwendung solcher prozess- und formstabiler und temperaturresistenter Materialien kann das Gaseinleit- und Gasaktivierungselement zuverlässig die Anregung des Prozessgases und die Verteilung des angeregten Prozessgases über die Austrittsöffnungen auf das Substrat gewährleisten.

Für das homogene Abscheiden einer Diamantschicht mit hoher Reinheit ist es zweckmäßig, die Abscheidekammer vor und während des Abscheideprozesses zu evakuieren. Zu diesem Zweck ist bevorzugt außerhalb der Vorrichtung eine Vakuumpumpe angeordnet, welche den für den Abscheidevorgang erforderlichen Unterdruck in der Abscheidekammer erzeugt.

Das zu beschichtende Substrat kann im Inneren der Abscheidekammer auf einer Substrathalterung angeordnet sein, welche vorzugsweise unterhalb des Gaseinleit- und Gasaktivierungselements angeordnet ist.

Bei einer weiteren Ausführungsform kann das Gaseinleit- und Gasaktivierungselement im Inneren eines zu beschichtenden hohlen Substrates angeordnet sein.

Die Substrathalterung kann, je nach Anforderung des Substrats, mit einer Kühlvorrichtung verbunden sein. Dies ist dann zweckmäßig, wenn das Substratmaterial zur Diamantabscheidung eine Temperatur erfordert, die beispielsweise unter 500 °C liegt.

Bei dem zugehörigen Verfahren wird die Wandung des Gaseinleit- und Gasaktivierungselements derart aufgeheizt, dass das im Strömungskanal des Gaseinleit- und Gasaktivierungselements strömende Prozessgas durch Stoßanregung und thermische Anregung angeregt wird. Zu diesem Zweck kann die Wandung des Gaseinleit- und Gasaktivierungselements auf eine Temperatur von mehr als 2000 °C, insbesondere von mehr als 2200 °C, aufgeheizt werden.

Bei dem Verfahren können weitere Prozessgase wie z.B. Stickstoff, Sauerstoff, etc. zur Beschleunigung des Diamantwachstums verwendet werden. Weiters kann die Diamantschicht zur Erzielung eines Halbleiters mit Elementen wie Bor, Phosphor, Stickstoff oder Schwefel etc. dotiert werden. Diese Zusatzstoffe können in gasförmigem, festem oder flüssigem Zustand in die Abscheidekammer eingebracht werden.

Die Erfindung wird nachstehend anhand von bevorzugten Ausführungsbeispielen, auf die sie jedoch nicht beschränkt werden soll, weiter erläutert. In der Zeichnung zeigt:
Fig. 1 eine teilweise geschnittene Ansicht einer erfindungsgemäßen Vorrichtung zum Aufbringen einer Diamantschicht auf ein Substrat durch chemische Gasphasenabscheidung, wobei ein Prozessgas über ein aufheizbares Gaseinleit- und Gasaktivierungselement in eine Abscheidekammer zugeführt wird;
Fig. 2 eine Ausführungsform des Gaseinleit- und Gasaktivierungselements der Vorrichtung gemäß Fig. 1;
Fig. 3 eine weitere Ausführungsform des Gaseinleit- und Gasaktivierungselements der Vorrichtung gemäß Fig. 1.

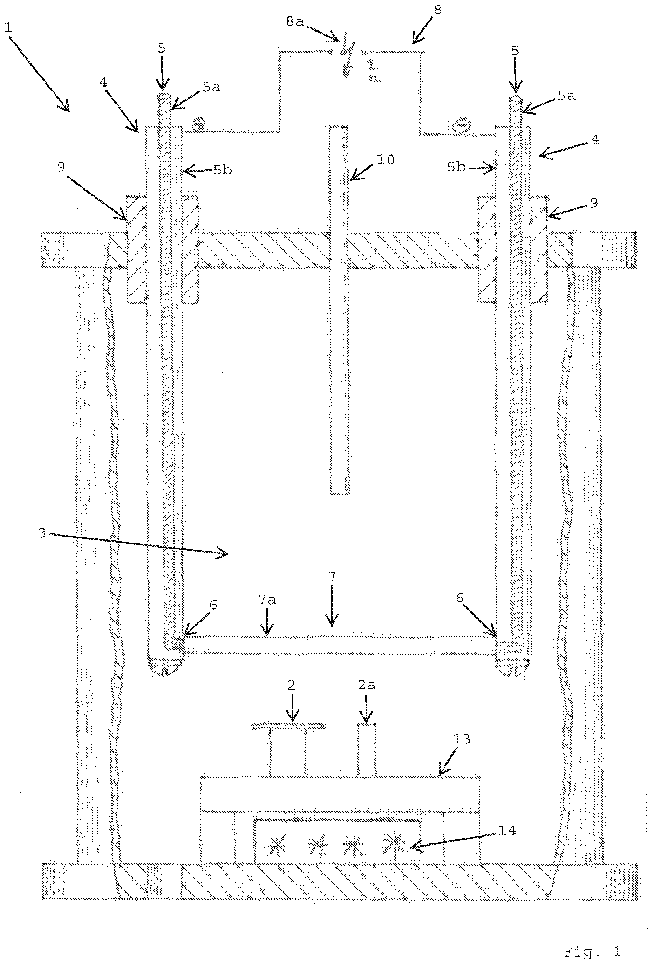

Fig. 1 zeigt eine Vorrichtung 1 zum Aufbringen einer Diamantschicht auf Substrate 2, 2a. Alternativ kann mit der Vorrichtung 1 eine andere Kohlenstoffschicht, beispielsweise Graphen, auf die Substrate 2, 2a aufgebracht werden. In der gezeigten Ausführung wird die Kohlenstoffschicht einerseits an der Außenseite des Substrats 2 und andererseits im Inneren des Substrats 2a abgeschieden. Die Vorrichtung 1 weist eine Abscheidekammer 3 zur Aufnahme der Substrate 2, 2a auf. Weiters ist ein Gas- und Stromzufuhrelement 4 vorgesehen. Das Gas- und Stromzufuhrelement 4 weist ein Innenelement 5a, insbesondere aus Edelstahl, zur Zufuhr eines Prozessgases, hier molekularer Wasserstoff, und ein Außenelement 5b aus einem elektrisch leitfähigen Material, beispielsweise Kupfer, zur Zuleitung eines elektrischen Stroms auf. An der Oberseite des Innenelements 5a ist eine Gaszufuhröffnung 5 ausgebildet, über die das Prozessgas in das Innere der Abscheidekammer 3 geführt wird.

Wie aus Fig. 1 weiters ersichtlich, ist das Gas- und Stromzufuhrelement 4 im Inneren der Abscheidekammer 3 über eine Klemm-Schraubverbindung 6 mit einem in der gezeigten Anordnung horizontal angeordneten Gaseinleit- und Gasaktivierungselement 7 derart verbunden, dass das Prozessgas über das Innenelement 5a des Gas- und Stromzufuhrelements 4 in das Gaseinleit- und Gasaktivierungselement 7 geleitet werden kann. Weiters ist eine (nur ganz schematisch) angedeutete Heizvorrichtung 8 vorgesehen, mit welcher im Betrieb eine Wand 7a des Gaseinleit- und Gasaktivierungselements 7 aufgeheizt wird. In der gezeigten Ausführungsform weist die Heizvorrichtung 8 eine (nur symbolisch veranschaulichte) Stromversorgung 8a, beispielsweise mit einem Gleichrichter, auf, mit welcher ein elektrischer Strom über das Außenelement 5b des Gas- und Stromzufuhrelements 4 zum Gaseinleit- und Gasaktivierungselement 7 geführt werden kann. Der elektrische Strom wird aufgrund des Widerstands des Materials des Gaseinleit- und Gasaktivierungselements 7 in Wärme umgewandelt, wodurch eine Aufheizung des Gaseinleit- und Gasaktivierungselements 7 bewerkstelligt wird. Bevorzugt wird die Wandung 7a des Gaseinleit- und Gasaktivierungselements 7 auf eine Temperatur von mehr als 2000 °C aufgeheizt. Dadurch kann neben einer thermischen Anregung auch eine Stoßanregung des Prozessgases erfolgen. Zu diesem Zweck besteht die Wandung 7a des Gaseinleit- und Gasaktivierungselements 7 bevorzugt aus einem Material ausgewählt aus hochschmelzendem Metall, wie Tantal, Molybdän, Wolfram, Rhenium, einem Keramikmaterial, Graphit, pyrolytischer Kohlenstoff oder Kompositmaterial daraus oder aus einem vorzugsweise faserverstärkten Kohlenstoff, ohne darauf beschränkt zu sein. Zwischen dem Außenelement 5b des Gas- und Stromzufuhrelements 4 und einem Gehäuse der Abscheidekammer 3 ist weiters eine elektrische Isolierung 9, beispielsweise aus einem Keramikmaterial, vorgesehen.

Wie aus Fig. 1 weiters ersichtlich, ist an der Oberseite der Abscheidekammer 3 ein weiteres, in der gezeigten Ausführung vertikales Gaseinleitelement 10 angeordnet, durch welches ein weiteres Prozessgas, insbesondere ein kohlenstoffhaltiges Prozessgas, vorzugsweise Methan, in die Abscheidekammer 3 einleitbar ist. Das kohlenstoffhaltige Prozessgas wird durch Überströmung des Gaseinleit- und Gasaktivierungselements 7 thermisch angeregt, sodass die notwendigen Kohlenstoff-Radikale (beispielsweise Methylradikale) erzeugt werden. Alternativ kann das kohlenstoffhaltige Prozessgas auch gemeinsam mit dem Wasserstoff in einem definierten Mischungsverhältnis durch das aufgeheizte Gaseinleit- und Gasaktivierungselement 7 zugeführt und dadurch aktiviert werden. Es können auch weitere Prozessgase, z.B. Stickstoff, Sauerstoff, Argon etc., über weitere Gaseinleitelemente (nicht dargestellt) zugeführt werden. Auch die Dotierung der Diamantschicht mit Elementen wie Bor, Phosphor, Stickstoff, Schwefel etc. ist in diesem Prozess - analog dem Stand der Technik - möglich.
Wie aus Fig. 1 weiters ersichtlich, ist im Inneren der Abscheidekammer 3 und unterhalb des Gaseinleit- und Gasaktivierungselements 7 eine Substrathalterung 13 angeordnet, auf welcher die Substrate 2, 2a angeordnet wird. Die Substrathalterung 13 ist über ein (nur schematisch eingezeichnetes) Kühlelement 14 kühlbar.

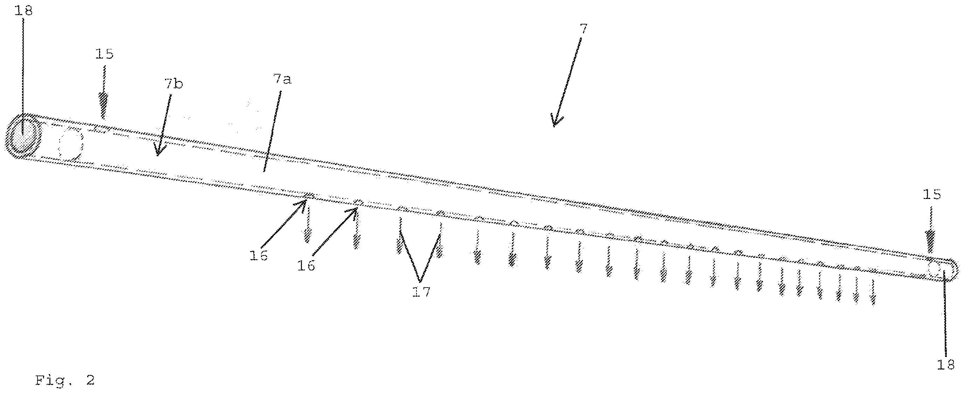

Fig. 2 zeigt eine Ausführungsform des Gaseinleit- und Gasaktivierungselements 7 mit einer kreisförmigen Querschnittsfläche. Das Gaseinleit- und Gasaktivierungselement 7 weist an gegenüberliegenden Endbereichen jeweils zumindest eine Eintrittsöffnung 15 auf, durch welche das Prozessgas, insbesondere Wasserstoff, in einen Strömungskanal 7b des Gaseinleit- und Gasaktivierungselements geführt wird. Zudem weist das Gaseinleit- und Gasaktivierungselement 7 eine Vielzahl in Längsrichtung des Gaseinleit- und Gasaktivierungselements 7 voneinander beabstandeter Austrittsöffnungen 16 auf, durch welche der aktivierte, atomare Wasserstoff in Richtung des Substrats 2 bzw. 2a abgegeben wird. Die Strömungsrichtung des Prozessgases in Richtung der Substrate 2 und 2a ist in Fig. 2 mit Pfeilen 17 veranschaulicht. Weiters sind in Fig. 2 schematisch Abschlusskörper 18 zum Abschluss des Strömungskanals 7b an den Enden des Gaseinleit- und Gasaktivierungselements 7 ersichtlich.

Das Verhältnis des Partialdrucks im Inneren des Gaseinleit- und Gasaktivierungselements zum Druck in der Abscheidekammer ist ausreichend hoch, um neben der thermischen Aktivierung auch eine Stoßanregung zu erreichen. Dadurch wird eine wesentlich höhere Anregungsrate von bis zu 90% erreicht. Darüber hinaus steigt die mittlere freie Weglänge der aktivierten Teilchen auf bis zu mehrere Zentimeter an, wodurch der Abstand zum Substrat erhöht werden kann, was wiederum eine gleichmäßigere Diamantschicht zur Folge hat.

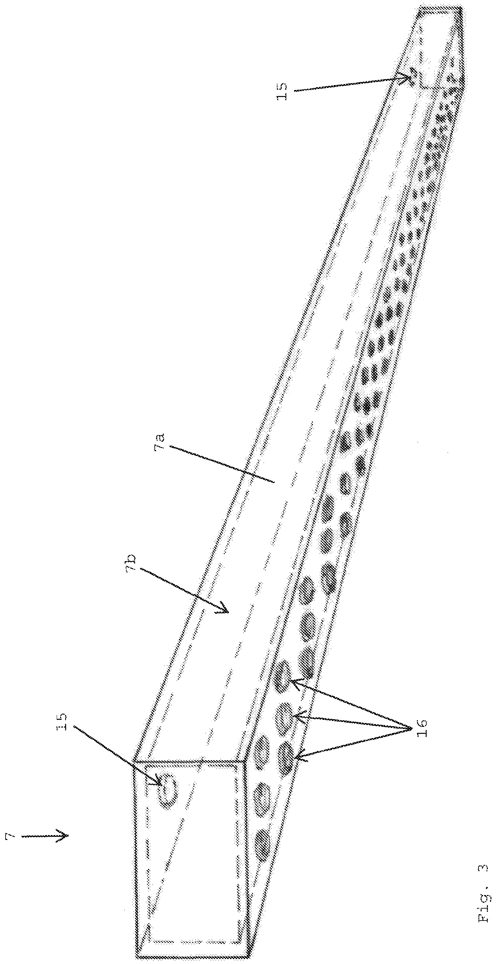

Fig. 3 zeigt eine alternative Ausführungsform des Gaseinleit- und Gasaktivierungselements 7 mit rechteckiger Querschnittsfläche. An der Oberseite des Gaseinleit- und Gasaktivierungselements 7 sind wiederum Eintrittsöffnungen 15 vorgesehen, durch welche das Prozessgas, insbesondere Wasserstoff (oder auch mehrere Prozessgase), vom Gas- und Stromzufuhrelement 4 in das Gaseinleit- und Gasaktivierungselement 7 geleitet wird. An der Unterseite des Gaseinleit- und Gasaktivierungselements 7 sind Austrittsöffnungen 16 angeordnet, über welche das Prozessgas in Richtung der Substrate 2 und 2a geführt wird.

## Patentansprüche

1. Vorrichtung (1) zum Aufbringen einer Kohlenstoffschicht, insbesondere einer Diamantschicht, auf ein Substrat (2, 2a) durch chemische Gasphasenabscheidung, mit einer Abscheidekammer (3), in welche ein Prozessgas, nämlich molekularer Wasserstoff und/oder ein Gemisch aus molekularem Wasserstoff und einem kohlenstoffhaltigen Gas, beispielsweise Methan, zuführbar ist, **dadurch gekennzeichnet, dass** ein Gaseinleit- und Gasaktivierungselement (7) in Form eines Hohlkörpers mit einem Strömungskanal (7b) für das Prozessgas, einer den Strömungskanal (7b) umgebenden Wandung (7a) und einer vom Strömungskanal (7b) in die Abscheidekammer (3) mündenden Austrittsöffnung (16) und eine Heizvorrichtung (8) zum Aufheizen der Wandung (7a) des Gaseinleit- und Gasaktivierungselementes (7) vorgesehen ist, wobei zum Abschluss des Strömungskanals (7b) Abschlusskörper (18) an Enden des Gaseinleit- und Gasaktivierungselements (7) angebracht sind, wobei ein weiteres Gaseinleitelement (10) zur Einbringung eines weiteren Prozessgases, nämlich eines kohlenstoffhaltigen Gases, vorzugsweise Methan, in die Abscheidekammer (3) vorgesehen ist, wobei das weitere Gaseinleitelement (10) so angeordnet ist, dass das dadurch eingeleitete weitere Prozessgas das Gaseinleit- und Gasaktivierungselement (7) überströmt.

2. Vorrichtung (1) nach Anspruch 1, **dadurch gekennzeichnet, dass** die Heizvorrichtung (8) zum Aufheizen der Wandung (7a) des Gaseinleit- und Gasaktivierungselements (7) auf eine Temperatur von mehr als 2000 °C, insbesondere von mehr als 2200 °C, vorzugsweise von mehr als 2400 °C, eingerichtet ist.

3. Vorrichtung (1) nach einem der Ansprüche 1 oder 2, **dadurch gekennzeichnet, dass** die Heizvorrichtung (8) eine mit der Wandung (7a) des Gaseinleit- und Gasaktivierungselements (7) verbundene Stromversorgung (8a) zur Widerstandheizung des Gaseinleit- und Gasaktivierungselements (7) aufweist.

4. Vorrichtung (1) nach einem der Ansprüche 1 bis 3, **dadurch gekennzeichnet, dass** das Gaseinleit- und Gasaktivierungselement (7) im Wesentlichen horizontal in der Abscheidekammer (3) angeordnet ist.

5. Vorrichtung (1) nach einem der Ansprüche 1 bis 4, **dadurch gekennzeichnet, dass** die zumindest eine Austrittsöffnung (16) an einer dem Substrat (2, 2a) zugewandten Unterseite des Gaseinleit- und Gasaktivierungselements (7) angeordnet ist.

6. Vorrichtung (1) nach einem der Ansprüche 1 bis 5, **dadurch gekennzeichnet, dass** das Gaseinleit- und Gasaktivierungselement (7) mehrere Austrittsöffnungen (16) aufweist.

7. Vorrichtung (1) nach einem der Ansprüche 1 bis 6, **dadurch gekennzeichnet, dass** das Gaseinleit- und Gasaktivierungselement (7) im Querschnitt im Wesentlichen kreisförmig oder rechteckig ist.

8. Vorrichtung (1) nach einem der Ansprüche 1 bis 7, **dadurch gekennzeichnet, dass** mehrere Gaseinleit- und Gasaktivierungselemente (7) vorgesehen sind, welche mittels der Heizvorrichtung (8) aufheizbar sind.

9. Vorrichtung (1) nach einem der Ansprüche 1 bis 8, **dadurch gekennzeichnet, dass** die Wandung (7a) des Gaseinleit- und Gasaktivierungselements (7) aus einem Metall, insbesondere Tantal, Molybdän, Wolfram, Rhenium, oder einem Keramikmaterial oder Graphit oder pyrolytischem Kohlenstoff oder einem Kompositmaterial daraus oder aus einem vorzugsweise faserverstärkten Kohlenstoff, insbesondere mit einer Beschichtung aus Pyrokohlenstoff, besteht.

10. Verfahren zum Aufbringen einer Kohlenstoffschicht, insbesondere einer Diamantschicht, auf ein Substrat (2, 2a) durch chemische Gasphasenabscheidung, wobei ein Prozessgas, nämlich Wasserstoff, über ein Gaseinleit- und Gasaktivierungselement (7) in eine Abscheidekammer (3) eingebracht wird, **dadurch gekennzeichnet, dass** eine Wandung (7a) des Gaseinleit- und Gasaktivierungselements (7) derart aufgeheizt wird, dass das im Strömungskanal (7b) des Gaseinleit- und Gasaktivierungselements (7) strömende Prozessgas durch Stoßanregung und thermische Anregung angeregt wird, wobei zum Abschluss des Strömungskanals (7b) Abschlusskörper (18) an Enden des Gaseinleit- und Gasaktivierungselements (7) angebracht sind, wobei ein weiteres Prozessgas, nämlich ein kohlenstoffhaltiges Gas, vorzugsweise Methan, über ein weiteres Gaseinleitelement (10) in die Abscheidekammer (3) eingebracht wird, wobei das weitere Prozessgas durch Überströmung des Gaseinleit- und Gasaktivierungselements (7) thermisch angeregt wird.

11. Verfahren nach Anspruch 10, **dadurch gekennzeichnet, dass** die Wandung (7a) des Gaseinleitelementes (7) auf eine Temperatur von mehr als 2000 °C, insbesondere von mehr als 2200 °C, aufgeheizt wird.

## Claims

1. A device (1) for applying a carbon layer, in particular a diamond layer, to a substrate (2, 2a) by chemical vapour deposition, said device comprising a deposition chamber (3), into which a process gas, in particular molecular hydrogen and/or a mixture of molecular hydrogen and a carbon-containing gas, for example methane, can be fed, **characterised in that** a gas inlet and gas activation element (7) is provided in the form of a hollow body with a flow channel (7b) for the process gas, a wall (7a) surrounding the flow channel (7b) and an outlet opening (16) feeding from the flow channel (7b) into the deposition chamber (3), and a heating device (8) is provided for heating the wall (7a) of the gas inlet and gas activation element (7), wherein termination bodies (18) are attached to ends of the gas inlet and gas activation element (7) in order to close off the flow channel (7b), wherein a further gas inlet element (10) is provided for introducing a further carbon-containing process gas, preferably methane, into the deposition chamber (3), wherein the further gas inlet element (10) is arranged so that the further carbon-containing process gas introduced thereby flows over the gas inlet and gas activation element (7).

2. The device (1) according to claim 1, **characterised in that** the heating device (8) is designed to heat the wall (7a) of the gas inlet and gas activation element (7) to a temperature of more than 2000 °C, in particular more than 2200 °C, preferably more than 2400 °C.

3. The device (1) according to any one of claims 1 or 2, **characterised in that** the heating device (8) comprises a power supply (8a), connected to the wall (7a) of the gas inlet and gas activation element (7), for the resistance heating of the gas inlet and gas activation element (7).

4. The device (1) according to any one of claims 1 to 3, **characterised in that** the gas inlet and gas activation element (7) is arranged substantially horizontally in the deposition chamber (3) .

5. The device (1) according to any one of claims 1 to 4, **characterised in that** the at least one outlet opening (16) is arranged on an underside of the gas inlet and gas activation element (7), the underside facing towards the substrate (2, 2a).

6. The device (1) according to any one of claims 1 to 5, **characterised in that** the gas inlet and gas activation element (7) comprises a number of outlet openings (16).

7. The device (1) according to any one of claims 1 to 6, **characterised in that** the gas inlet and gas activation element (7) is substantially circular or rectangular in cross-section.

8. The device (1) according to any one of claims 1 to 7, **characterised in that** a plurality of gas inlet and gas activation elements (7) are provided which can be heated by means of the heating device (8).

9. The device (1) according to any one of claims 1 to 8, **characterised in that** the wall (7a) of the gas inlet and gas activation element (7) consists of a metal, in particular tantalum, molybdenum, tungsten, rhenium, or a ceramic material, or graphite, or pyrolytic carbon or a composite material thereof, or of a preferably fibre-reinforced carbon, in particular with a coating formed from pyrocarbon.

10. A method for applying a carbon layer, in particular a diamond layer, to a substrate (2, 2a) by chemical vapour deposition, wherein a process gas, preferably hydrogen, is introduced into a deposition chamber (3) via a gas inlet and gas activation element (7), **characterised in that** a wall (7a) of the gas inlet and gas activation element (7) is heated in such a way that the process gas flowing in the flow channel (7b) of the gas inlet and gas activation element (7) is excited by impact excitation and thermal excitation, wherein termination bodies (18) are attached to ends of the gas inlet and gas activation element (7) in order to close off the flow channel (7b), wherein a further carbon-containing process gas, preferably methane, is introduced into the deposition chamber (3) via a further gas inlet element (10), wherein the further carbon-containing process gas is thermally excited by flowing over the gas inlet and gas activation element (7).

11. The method according to claim 10, **characterised in that** the wall (7a) of the gas inlet element (7) is heated to a temperature of more than 2000 °C, in particular more than 2200 °C.

## Revendications

1. Dispositif (1) pour l'application d'une couche de carbone, plus particulièrement d'une couche de diamant, sur un substrat (2, 2a) par dépôt chimique en phase vapeur, avec une chambre de dépôt (3), dans laquelle un gaz de process, à savoir de l'hydrogène moléculaire et/ou un mélange d'hydrogène moléculaire et d'un gaz contenant du carbone, par exemple du méthane, peut être introduit, **caractérisé en ce qu'**un élément d'introduction et d'activation de gaz (7), sous la forme d'un corps creux avec un canal d'écoulement (7b) pour le gaz de process, une paroi (7a) entourant le canal d'écoulement (7b) et une ouverture de sortie (16) débouchant du canal d'écoulement (7b) dans la chambre de dépôt (3) et un dispositif de chauffage (8) pour le chauffage de la paroi (7a) de l'élément d'introduction et d'activation de gaz (7), est prévu, moyennant quoi, pour l'obturation du canal d'écoulement (7b), des corps d'obturation (18) sont montés aux extrémités de l'élément d'introduction et d'activation de gaz (7), un autre élément d'introduction de gaz (10) étant prévu pour l'introduction d'un autre gaz de process, à savoir un gaz contenant du carbone, de préférence du méthane, dans la chambre de dépôt (3), l'autre élément d'introduction de gaz (10) étant disposé de façon à ce que l'autre gaz de process ainsi introduit inonde l'élément d'introduction et d'activation de gaz (7).

2. Dispositif (1) selon la revendication 1, **caractérisé en ce que** le dispositif de chauffage (8) est conçu pour le chauffage de la paroi (7a) de l'élément d'introduction et d'activation de gaz (7) à une température supérieure à 2000 °C, plus particulièrement supérieure à 2200 °C, de préférence supérieure à 2400 °C.

3. Dispositif (1) selon la revendication 1 ou 2, **caractérisé en ce que** le dispositif de chauffage (8) comprend une alimentation électrique (8a) reliée avec la paroi (7a) de l'élément d'introduction et d'activation de gaz (7), pour le chauffage par résistance de l'élément d'introduction et d'activation de gaz (7).

4. Dispositif (1) selon l'une des revendications 1 à 3, **caractérisé en ce que** l'élément d'introduction et d'activation de gaz (7) est disposé globalement horizontalement dans la chambre de dépôt (3).

5. Dispositif (1) selon l'une des revendications 1 à 4, **caractérisé en ce que** l'au moins une ouverture de sortie (16) est disposée au niveau d'un côté inférieur, orienté vers le substrat (2, 2a), de l'élément d'introduction et d'activation (7).

6. Dispositif (1) selon l'une des revendications 1 à 5, **caractérisé en ce que** l'élément d'introduction et d'activation de gaz (7) comprend plusieurs ouvertures de sorties (16).

7. Dispositif (1) selon l'une des revendications 1 à 6, **caractérisé en ce que** l'élément d'introduction et d'activation de gaz (7) présente une section transversale globalement circulaire ou rectangulaire.

8. Dispositif (1) selon l'une des revendications 1 à 7, **caractérisé en ce que** plusieurs éléments d'introduction et d'activation de gaz (7) sont prévus, qui peuvent être chauffés au moyen du dispositif de chauffage (8).

9. Dispositif (1) selon l'une des revendications 1 à 8, **caractérisé en ce que** la paroi (7a) de l'élément d'introduction et d'activation de gaz (7) est constituée d'un métal, plus particulièrement de tantale, de molybdène, de tungstène, de rhénium, ou d'un matériau de type céramique ou graphite ou de carbone pyrolytique ou d'un matériau composite de ceux-ci ou de carbone de préférence renforcé par des fibres, plus particulièrement avec un revêtement en pyrocarbone.

10. Procédé d'application d'une couche de carbone, plus particulièrement d'une couche de diamant, sur un substrat (2, 2a) par dépôt chimique en phase vapeur, un gaz de process, à savoir de l'hydrogène, étant introduit, par l'intermédiaire d'un élément d'introduction et d'activation de gaz (7), dans une chambre de dépôt (3), **caractérisé en ce qu'**une paroi (7a) de l'élément d'introduction et d'activation de gaz (7) est chauffé de façon à ce que le gaz s'écoulant dans le canal d'écoulement (7b) de l'élément d'introduction et d'activation de gaz (7) soit excité par des chocs ou par excitation thermique, moyennant quoi, pour l'obturation du canal d'écoulement (7b), des corps d'obturation (18) sont montés aux extrémités de l'élément d'introduction et d'activation de gaz (7), un autre gaz de process, à savoir un gaz contenant du carbone, de préférence du méthane, étant introduit, par l'intermédiaire d'un autre élément d'introduction de gaz (10), dans la chambre de dépôt (3), l'autre gaz de process étant excité thermiquement par inondation de l'élément d'introduction et d'activation de gaz (7).

11. Procédé selon la revendication 10, **caractérisé en ce que** la paroi (7a) de l'élément d'introduction de gaz (7) est chauffé à une température supérieure à 2000 °C, plus particulièrement supérieure à 2200 °C.
